# EUROPEAN PATENT SPECIFICATION

(11) **EP 2 773 171 B1**
(45) Date of publication and mention of the grant of the patent: **07.08.2019**
(21) Application number: 13185691.6
(22) Date of filing: 24.09.2013
(51) Int. Cl.: H01F 27/08, H05K 7/20

(54) **Electronic device**
Elektronische Vorrichtung
Dispositif électronique

(30) Priority: 01.03.2013 CN 201320095672 U
(43) Date of publication of application: 03.09.2014
(73) Proprietor: OMRON Corporation, Shiokoji-dori, Shimogyo-Ku Kyoto Kyoto 600-8530 (JP)
(72) Inventor: Ueuchi, Masayuki, Kyoto, Kyoto 600-8530 (JP); Onishi, Hiroyuki, Kyoto, Kyoto 600-8530 (JP); Okada, Kei, Kyoto, Kyoto 600-8530 (JP); Kawano, Hiroki, Kyoto, Kyoto 600-8530 (JP); Kubo, Masahiko, Kyoto, Kyoto 600-8530 (JP); Kuroko, Masashi, Kyoto, Kyoto 600-8530 (JP); Takatori, Koji, Kyoto, Kyoto 600-8530 (JP); Tanino, Kohei, Kyoto, Kyoto 600-8530 (JP); Nishida, Masami, Kyoto, Kyoto 600-8530 (JP); Niwa, Hiroki, Kyoto, Kyoto 600-8530 (JP); Marumo, Katsuya, Kyoto, Kyoto 600-8530 (JP); Minamide, Kenhachiro, Kyoto, Kyoto 600-8530 (JP)
(74) Representative: Horn Kleimann Waitzhofer Patentanwälte PartG mbB

(56) References cited:
- US-A- 5 016 139

## Description

### BACKGROUND OF THE INVENTION

### TECHNICAL FIELD

The present invention relates to an electronic device.

### RELATED ART

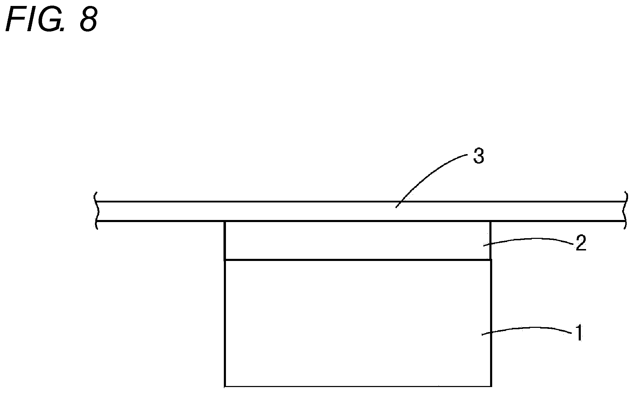

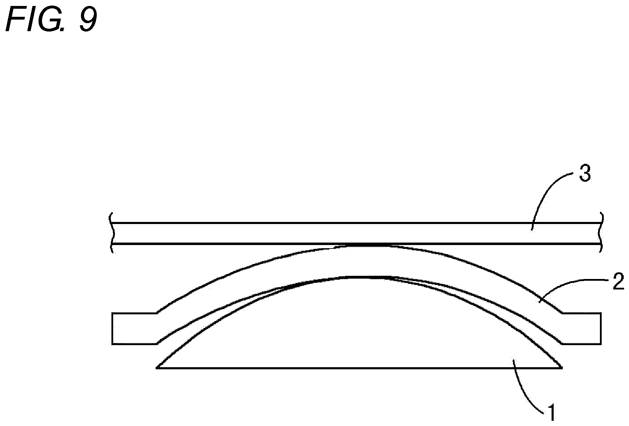

Previously, when a heat generating component 1 in an electronic device is cooled, a flat heat dissipation sheet 2 is provided between the upper surface of the heat generating component 1 and a flat metal frame 3 (which may also be constituted by a metal casing) of the electronic device as shown in Fig. 8, thus, heat generated by the heat generating component 1 is transferred to the metal frame 3 via the heat dissipation sheet 2 and then discharged to atmosphere, wherein the heat dissipation sheet 2 constitutes a conventional heat sink structure. However, as shown in Fig. 9, when the upper surface of the heat generating component 1 is, for example, a curved surface rather than a flat surface, although the flat heat dissipation sheet 2 has a certain flexibility, it is only in contact with the top of the curved surface, therefore the contact area between the heat dissipation sheet 2 and the heat generating component 1 gets smaller, thus, it is difficult to efficiently cool the heat generating component 1.

Further, since only the top of the deformed heat dissipation sheet 2 is in contact with the flat metal frame 3, the contact area between the heat dissipation sheet 2 and the metal frame 3 gets smaller and heat transferred to the heat dissipation sheet 2 from the heat generating component 1 may not be efficiently transferred to the metal frame 3, and thus, it is more difficult to efficiently cool the heat generating component 1.

US 5,016,139 A describes an electronic power supply which employs energy storage capacitors has an enclosure defining a housing including a base and a cover. Integral receivers extend from the underside of the top of the cover in registration with the carrier and engage capacitors to clamp the capacitors in a fixed position within the housing. The housing exterior includes a thermal radiator consisting of multiple fins which extend outwardly from the receivers for dissipating heat generated in the capacitors.

### SUMMARY

The present invention has been devised to solve the problems described above, and an object thereof is to provide an electronic device configured to efficiently cool a heat generating component with a complex shape.

In accordance with one aspect of the present invention, in an electronic device is described according to technical solution 1,
the electronic device is provided with a substrate, a heat generating device, a heat sink structure comprising a heat sink and deformable heat dissipation sheets, as well as a flat metal frame, the heat generating component is provided on the substrate, the heat dissipation sheet is in areal contact with at least part of the outer surface on one side of the heat generating component, the outer surface being opposite to the substrate, the heat sink covers a part of the heat generating component with the heat dissipation sheet interposed therebetween, and further, the heat sink is attached to (or provided on) the metal frame, and the outer surface of the heating component is a non-flat (uneven) surface.

The heat sink comprises two side walls and a flat main body part attached to the metal frame, the two side walls extend towards one side opposite to the metal frame from two opposite ends of the main body part, and the main body part and the two side walls abut against the outer surface with the heat dissipation sheet interposed therebetween.

The electronic device as described in the technical solution 2 is as described according in technical solution 1, wherein
the side walls are curved or flat and define an angle with the main body part.

The electronic device as described in the technical solution 3 is as described technical solution 1 or 2, wherein
the end parts of the side walls are curved to form curved parts, and the curved parts abut against the outer surface with the heat dissipation sheet interposed therebetween.

The electronic device as described in the technical solution 4 is as described in any of technical solutions 1 to 3, wherein
one or more than two screws are attached to the main body part of the heat sink.

The electronic device as described in the technical solution 5 is as described in any of technical solutions 1 to 4, wherein
when two or more heat generating components are provided, the quantity of the heat sink is equal to or smaller than that of the heat generating components, and one or more heat dissipation sheet is provided.

The electronic device as described in the technical solution 6is as described in any of technical solutions 1 to 5, wherein
the heat sink is made of a material with high heat conductivity.

The electronic device as described in the technical solution 7 is as described in any of technical solutions 1 to 6, wherein
the electronic device is a switching power supply, and the heat generating component is a transformer.

The electronic device as described in the technical solution 8 is described according to technical solution 7, wherein
the transformer is provided with a base mounted on the substrate and a heat generating part mounted in the base, the heat generating part is provided with a protruding part configured to protrude towards one side opposite to the substrate from the base, and the heat dissipation sheet is in areal contact with the outer surface of the protruding part.

The electronic device as described in the technical solution 9 is described according to technical solution 8, wherein
the outer surface of the producing part is a curved surface, or a surface including a curved surface and a flat surface, or a surface including two or more flat surfaces.

In the event that the electronic device provided by the present invention is employed, even directing at the heat generating component with a complex shape, the contact area between the heat sink structure and the heat generating component may get larger, thereby efficiently cooling the heat generating component.

### BRIEF DESCRIPTION OF THE DRAWINGS

Fig.1 is a schematic perspective view illustrating a state where the transformer in the switching power supply is separated from the heat dissipation sheet according to this embodiment.
Fig. 2 is a schematic perspective view illustrating a state where the heat dissipation sheet is mounted on the transformer in the switching power supply according to this embodiment.
Fig. 3 is a schematic sectional view illustrating a state where the heat dissipation sheet is mounted on the transformer.
Fig. 4 is a schematic perspective view illustrating a shell installed with the heat sink of the switching power supply according to this embodiment.
Fig. 5 is a schematic perspective view illustrating the heat sink in the heat sink structure.
Fig. 6 is a sectional view of the heat sink.
Figs. 7A, 7B and 7C are schematic sectional views illustrating a state where the transformer is in contact with the heat sink.
Fig. 8 is a sectional view illustrating a heat generating component installed with the conventional heat sink structure.
Fig. 9 is a sectional view illustrating a heat generating component installed with a conventional heat sink structure.

### DETAILED DESCRIPTION

The present invention is described in a more detailed way with reference to figures below. According to the present embodiment, as an electronic device, a switching power supply is given as an example, but the electronic device is not limited thereto, and may also be another device with heat generating components. Further, as an example of the heat generating component, a transformer is given as an example, however, the heat generating component is not limited thereto, and any component configured to generate heat while operating may be applicable to the heat sink structure of the present embodiment.

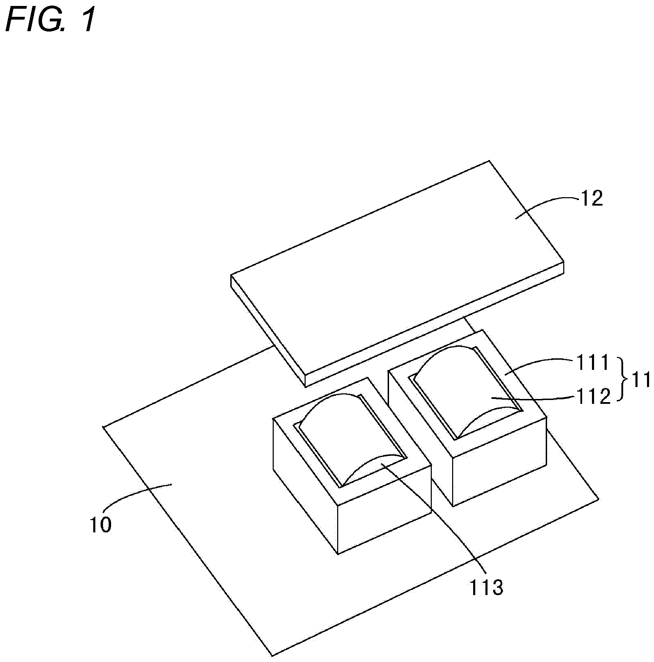

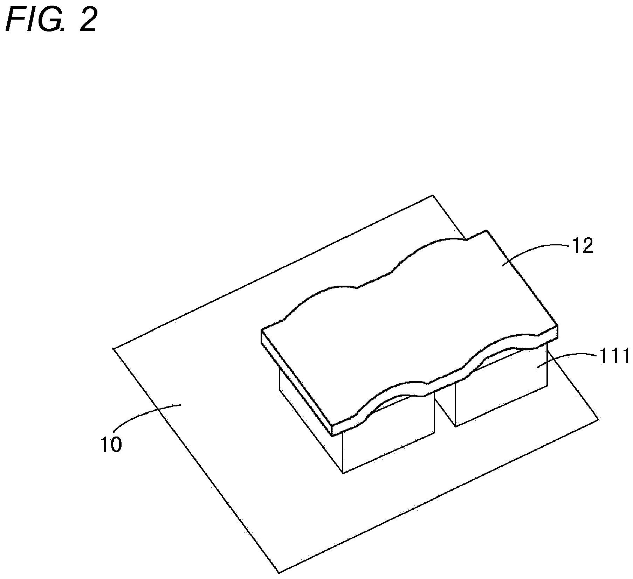

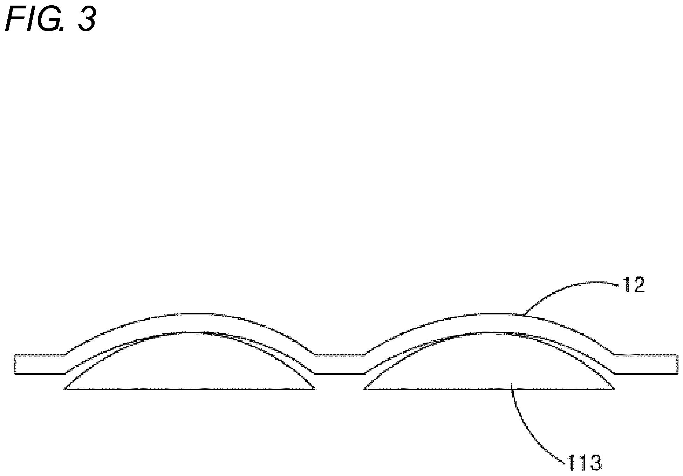

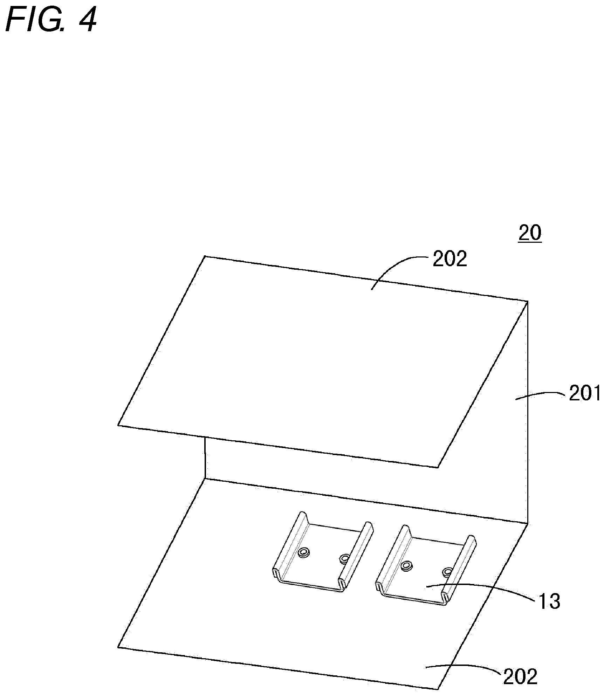

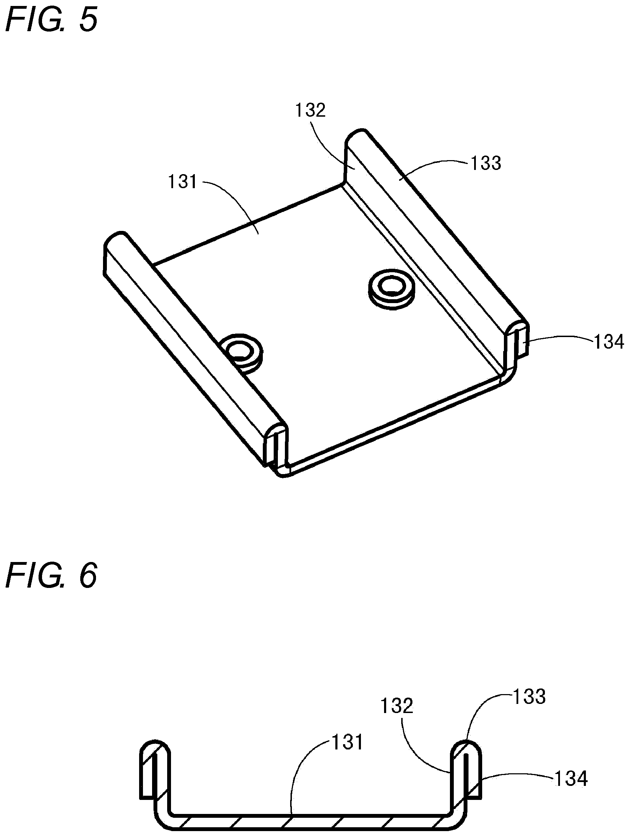

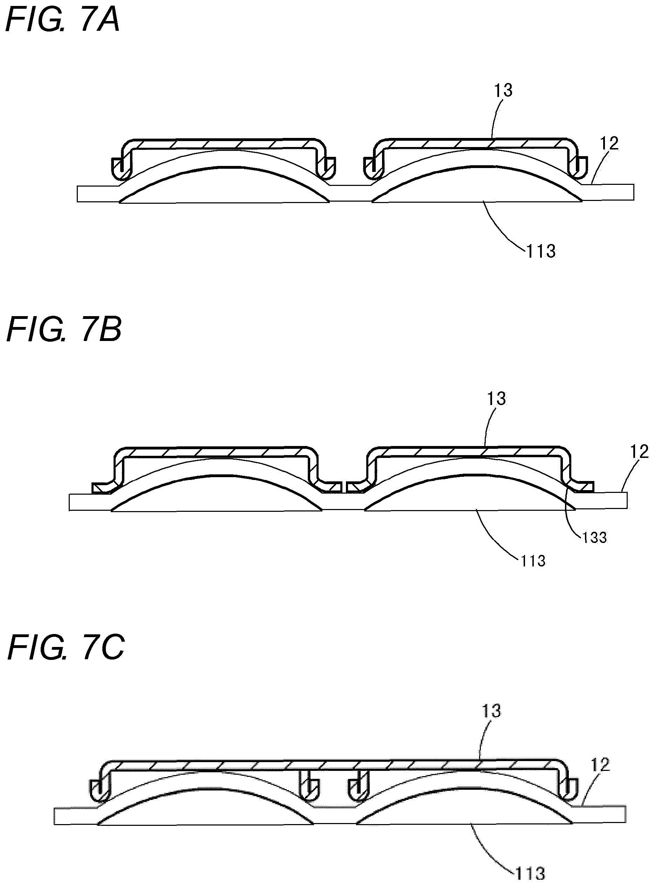

Fig. 1 is a schematic perspective view illustrating a state where a transformer in a switching power supply is separated from the heat dissipation sheet according to this embodiment. Fig. 2 is a schematic perspective view illustrating a state where the heat dissipation sheet is provided on the transformer in the switching power supply according to this embodiment. Fig. 3 is a schematic sectional view illustrating a state where the heat dissipation sheet is provided on the transformer. Fig. 4 is a schematic perspective view illustrating a shell installed (provided) with the heat sink of the switching power supply according to this embodiment. Fig. 5 is a schematic perspective view illustrating the heat sink in the heat sink structure. Fig. 6 is a sectional view of the heat sink. Figs. 7A to 7C are schematic sectional views illustrating a state where the transformer is in contact with the heat sink. Fig. 8 is a sectional view illustrating a heat generating component installed with a conventional heat sink structure. Fig. 9 is a sectional view illustrating the heat generating component installed with a conventional heat sink structure.

The switching power supply provided by the present embodiment is provided with a substrate 10 and a shell 20. Further, as shown in Fig. 1, various heat generating components, such as a transformer 11, are provided on the upper surface of the substrate 10, and the transformer 11 is provided with a base 111 and a core part 112 provided on the base 111 and working as a heat generating part, and furthermore, the core part 112 is provided with a protruding part 113 configured to protrude towards one side opposite to the substrate 10 from the base 111. As the heat generating part of the transformer 11 is the core part 112, for illustrative purposes, the upper surface of the protruding part 113 of the core part 112 is called "the upper surface of the transformer" (the outer surface of one side of the transformer which is opposite to the substrate 10). As shown in Fig. 1, the upper surface of the transformer 11 is a curved surface rather than a flat surface. Further, the shape of the upper surface of the transformer 11 is not limited thereto, the upper surface may be a surface including a curved surface and a flat surface, or a surface including two or more flat surfaces. Further, according to the present embodiment, two transformers 11 are illustrated, but the quantity of the transformers 11 is not limited thereto, one or more than two transformers may also be provided. Further, according to the present embodiment, the transformer 11 is provided with the base 111, but it may alternatively not be provided with a base 111, and in this case a cooling effect of the transformer is the same as that of the transformer with the base.

As shown in Fig. 1, in order to cool the transformer 11, it is necessary to provide a heat dissipation sheet 12 on the outer surface (the upper surface) of one side of the transformer 11, which is opposite to the substrate 10, and the heat dissipation sheet 12 is deformable. As shown in Fig. 2, after covering the transformer 11, the heat dissipation sheet 12 may approximately and appropriately deform in correspondence with the shape of a protruding part 113 of the transformer 11. However, even if the heat dissipation sheet 12 is flexible, when the upper surface of the protruding part 113 of the transformer 11 has a complex shape, as shown in Fig.3, the heat dissipation sheet 12 is only in contact with the top of the protruding part 13 of the transformer 11 rather than coming into sufficient contact with the side surface of the protruding part 113 of the transformer 11. Under such circumstances, although no graphical representation is provided, if the deformed heat dissipation sheet 12 comes into direct contact with a flat metal frame as shown in Fig.8, the heat dissipation sheet 12 may be only in partial contact with the metal frame, which may seriously influence the cooling effect of the transformer.

In addition, the situation that one heat dissipation sheet 12 is employed to cover two transformers 11 is shown in Figs. 1 and 2, but it is not limited thereto, and the same number of heat dissipation sheets as there are transformers 11 may also be employed to cover each transformer 11.

As shown in Fig. 4, a shell 20 is formed by bending two ends of a flat metal plate towards the same direction, and comprises a main body part 201 and two side walls 202 vertical to the main body part 201. Two heat sinks 13 are provided on the inner surface of one side wall 202 (i,e., the metal frame in the present embodiment) of the shell 20, but alternatively, only one heat sink 13 may be mounted. That is, according to the present embodiment, the number of heat sinks 13 may be the same as, or alternatively, may be smaller than that of the transformers 11.

The heat sinks 13 each have a shape corresponding to that of the transformers 11. According to the present embodiment, each heat sink 13 is formed by bending two ends of the flat metal plate made of materials, such as aluminum, with high heat conductivity. The heat sink 13 comprises a flat main body part 131 and two side walls 132 vertical to the main body part 131. Under the circumstance that the heat sink 13 is provided on the inner surface of the side wall 202, the two side walls 132 extend from two opposite ends of the main body part 131 to one side opposite to the side wall 202. Under the circumstance that a substrate 10 is provided in the shell 20, the main body part 131 and the two side walls 132 of the heat sink 13 abut against the protruding part 113 of the transformer 11 with the heat dissipation sheet 12 interposed therebetween, so that the heat dissipation sheet 12 may be in areal contact with the outer surface of one side of the protruding part 113, which is opposite to the substrate 10. The side wall 132 may also be further curved to form a curved part 133 as shown in Fig. 5, and a curved part 134 is in areal contact with the side wall 132, or it may also be separated from the side wall 132 by a certain distance. If the curved part 133 is employed to press the heat dissipation sheet 12, the contact area between the heat dissipation sheet 12 and the protruding part 113 of the transformer 11 may be increased, and the contact area between the heat dissipation sheet 12 and the heat sink 13 may be increased. Further, the main body part 131 is flat so that the effective contact area between the heat sink 13 fixed on the shell 20 and the shell 20 is ensured, and accordingly, the cooling effect of the transformer 11 may be improved. The heat sink 13 may use other shapes, for instance, the flat side wall 132 may not be configured to be vertical to the main body part 131, or the flat side wall 132 is made into a curved shape and the like. The contact area between the side wall 132 and the heat dissipation sheet 12 is further increased by enabling the side wall 132 to form a specified angle with the main body part 131, thus, the contact area of the side wall 132 and the heat dissipation sheet 12 is increased, thereby further increasing the contact area between the heat dissipation sheet 12, and the protruding part 113 of the transformer 11, and a heat sink may be configured to any shape as long as the contact area between the heat dissipation sheet 12 and the protruding part 113 of the transformer 11 is favorably increased.

The flat main body part 131 of the heat sink 13 is provided with two screw holes and is fixed on the inner surface of a side wall 202 of the shell 20 via two screws so as to prevent the efficiency of heat transfer from the heat sink 13 to the shell 20 from being reduced by the contact area between the heat sink 13 and the side wall 202 getting smaller when the heat sink 13 inclines. Further, the main body part 131 may also be provided with three or more screw holes configured for installation of three or more screws, and thus, the heat sink 13 is fixed on the side wall 202 more stably. Alternatively, the main body part 131 may also be provided with one screw hole configured to installation of one screw.

A mounting method for mounting the substrate 10 installed with the transformer 11 to the shell 20 is described as below.

As shown in Fig. 2, the substrate 10 installed with the transformer 11 is inserted into the shell 20 as shown in Fig. 4, in a direction approximately parallel to the side wall 202 of the shell 20. The transformer 11 is arranged to be opposite to the heat sink 13 provided on the side wall 202; furthermore, the substrate 10 is pushed towards the side wall 202 installed with the heat sink 13 (i.e., the metal frame of the present embodiment), so that a protruding part 113 of the transformer 11 enters a space between the two side walls 132 of the heat sink 13, thereby enabling the heat sink 13 to cover a part of transformer 11; and finally, as shown in Fig. 7A, the main body part 131 of the heat sink 13 abuts against the top of the protruding part 113 of the transformer 11 with the heat dissipation sheet 12 interposed therebetween, two side walls 132 abut against the side surface of the protruding part 131 of the transformer 11 via the heat dissipation sheet 12, and thus, the heat dissipation sheet 12 is in areal contact with the protruding part 113 of the transformer 11. It should be noted that the term "areal contact" (also referred to as "surface contact") as used in this specification refers to the case that the contact region extends over a certain surface area, as opposed to "point contact" or "linear contact", where the contact is substantially point-shaped or line-shaped. Accordingly, the contact area between the heat dissipation sheet 10 and the protruding part of the transformer 11 is increased, and the cooling effect on the transformer 11 is improved.

Further, a schematic sectional view showing the state when a heat sink 13 of another embodiment is in contact with the protruding part 113 with the heat dissipation sheet 12 interposed therebetween is disclosed in Fig. 7B. The contact area between the heat sink 13 and the heat dissipation sheet 12 may be further increased by using a curved part 133 of the heat sink 13 as shown in Fig. 7B, and the cooling effect on the transformer 11 may be improved.

Further, two heat sinks 13 as shown in Fig. 7A may be formed in one piece, and the heat dissipation sheet 12 is pushed by the heat sink 13 as shown in Fig. 7C.

Further, in the embodiment described above, situations where the protruding part 113 has a regular curved surface (an arc-shaped surface) and the heat dissipation sheet 12 is in areal contact with the overall outer surface of the protruding part 113 are illustrated, however, the heat dissipation sheet 12 is only in areal contact with a part of the outer surface of the protruding part 113 if the protruding part 113 is not shaped as a regular curved surface, and the contact area between the heat dissipation sheet 12 and the protruding part 113 may also be increased by adopting the heat sink 13 described above.

As described above, if the switching power supply of the present embodiment is employed, the contact area between the heat sink structure and the heat generating component may also get larger even if the heat generating component has a complex shape, and the heat generating component may be cooled efficiently.

## Claims

1. An electronic device, comprising:
a substrate (10);
a heat generating component (11) mounted on the substrate (10);
a heat sink structure comprising a heat sink (13) and a deformable heat dissipation sheet (12); and
a flat metal frame, wherein
the heat dissipation sheet (12) is in areal contact with at least part of the outer surface of the heat generating component (11), said outer surface being arranged opposite to the substrate (10),
the heat sink (13) covers a part of heat generating component (11) with the dissipation sheet (12) interposed therebetween, and is provided on the metal frame, and
the outer surface of the heating component (11) is a non-flat surface;
**characterized in that**
the heat sink (13) comprises two side walls (132) and a flat main body part (131) attached to the metal frame, the two side walls (132) extend from two opposite ends of the main body part (131) to one side opposite to the metal frame, and the main body part (131) and the two side walls (132) abut against the outer surface with the heat dissipation sheet (12) interposed therebetween.

2. The electronic device according to Claim 1, wherein
the side walls (132) are curved or flat, and form an angle with the main body part (131).

3. The electronic device according to Claim 1 or 2, wherein
the end parts of the side walls (132) are bent to form curved parts (133), and the curved parts (133) abut against the outer surface with the heat dissipation sheet (12) interposed therebetween.

4. The electronic device according to any of Claims 1 to 3, wherein
the main body part (131) of the heat sink (13) is provided with one or two or more screws.

5. The electronic device according to any of Claims 1 to 4, wherein
when more than two heat generating components (11) are provided, the number of heat sinks (13) is equal to or smaller than that of the heat generating components (11), and one or more heat dissipation sheet (12) is provided.

6. The electronic device according to Claims 1 to 5, wherein
the heat sink (13) is made of a material with high heat conductivity.

7. The electronic device according to any of Claims 1 to 6, wherein
the electronic device is a switching power supply, and the heat generating component (11) is a transformer.

8. The electronic device according to Claim 7, wherein
the transformer (11) is provided with a base (111) attached to the substrate (10) and a heat generating part (112) attached to the base (111),
the heat generating part (112) is provided with a protruding part (113) configured to protrude from the base (111) to one side opposite to the substrate (10), and the heat dissipation sheet (12) is in areal contact with the outer surface of the protruding part (113).

9. The electronic device according to Claim 8, wherein
the outer surface of the protruding part (113) is a curved surface, a surface including a curved surface and a flat surface, or a surface including two or more flat surfaces.

## Patentansprüche

1. Elektronische Vorrichtung, welche aufweist:
ein Substrat (10);
eine Wärme erzeugende Komponente (11), die auf dem Substrat (10) montiert ist;
eine Kühlkörperstruktur, die einen Kühlkörper (13) und ein verformbares Wärmeabführblech (12) aufweist; und
einen flachen Metallrahmen, wobei
das Wärmeabführblech (12) in einem Flächenkontakt mit zumindest einem Teil der äußeren Fläche der Wärme erzeugenden Komponente (11) ist, wobei die äußere Fläche gegenüber dem Substrat (10) angeordnet ist,
wobei der Kühlkörper (13) einen Teil der Wärme erzeugenden Komponente (11) bedeckt, wobei das Abführblech (12) dazwischen eingefügt ist, und an dem Metallrahmen vorgesehen ist, und
die äußere Fläche der wärmenden Komponente (11) eine nicht-flache Fläche ist;
**dadurch gekennzeichnet, dass**
der Kühlkörper (13) zwei Seitenwände (132) und einen flachen Hauptteil (131) aufweist, der an dem Metallrahmen befestigt ist, wobei die zwei Seitenwände (132) sich von zwei gegenüberliegenden Enden des Hauptkörpers (131) auf eine Seite gegenüber dem Metallrahmen erstrecken, und wobei der Hauptteil (131) und die zwei Seitenwände (132) an die äußere Fläche angrenzen, wobei das Wärmeabführblech (12) dazwischen eingefügt ist.

2. Elektronische Vorrichtung gemäß Anspruch 1, wobei
die Seitenwände (132) gekrümmt oder flach sind, und einen Winkel mit dem Hauptteil (131) bilden.

3. Elektronische Vorrichtung gemäß Anspruch 1 oder 2, wobei
die Enden der Seitenwände (132) gebogen sind, um gekrümmte Abschnitte (133) zu bilden, und die gekrümmten Abschnitte (133) an die äußere Fläche angrenzen, wobei das Wärmeabführblech (12) dazwischen eingefügt ist.

4. Elektronische Vorrichtung gemäß einem der Ansprüche 1 bis 3, wobei
der Hauptteil (131) des Kühlkörpers (13) mit einem oder zwei oder mehr Schrauben versehen ist.

5. Elektronische Vorrichtung gemäß einem der Ansprüche 1 bis 4, wobei
wenn mehr als zwei Wärme erzeugende Komponenten (11) vorgesehen sind, die Anzahl der Kühlkörper (13) gleich oder kleiner als die der Wärme erzeugenden Komponenten (11) ist und ein oder mehr Wärmeabführbleche (12) vorgesehen sind.

6. Elektronische Vorrichtung gemäß Ansprüchen 1 bis 5, wobei der Kühlkörper (13) aus einem Material mit einer großen Wärmeleitfähigkeit hergestellt ist.

7. Elektronische Vorrichtung gemäß einem der Ansprüche 1 bis 6, wobei
die elektronische Vorrichtung ein Schaltnetzteil ist und die Wärme erzeugende Komponente (11) ein Transformator ist.

8. Elektronische Vorrichtung gemäß Anspruch 7, wobei der Transformator (11) mit einer Basis (111), die an dem Substrat (10) befestigt ist, und mit einem Wärme erzeugenden Teil (112) versehen ist, das an der Basis befestigt ist,
wobei der Wärme erzeugende Teil (112) mit einem vorspringenden Teil (113) versehen ist, der eingerichtet ist, von der Basis (111) zu einer Seite gegenüber dem Substrat (10) vorzuspringen, und das Wärmeabführblech (12) in einem Flächenkontakt mit der äußeren Fläche des vorspringenden Teils (113) ist.

9. Elektronische Vorrichtung gemäß Anspruch 8, wobei
die äußere Fläche des vorspringenden Teils (113) eine gekrümmte Fläche, eine Fläche, die eine gekrümmte Fläche und eine flache Fläche umfasst, oder eine Fläche ist, die zwei oder mehr flache Flächen umfasst.

## Revendications

1. Dispositif électronique, comprenant :
un substrat (10) ;
un composant thermogène (11) monté sur le substrat (10) ;
une structure de dissipateur thermique comprenant un dissipateur thermique (13) et une feuille de dissipation de chaleur déformable (12) ; et
un châssis métallique plat, dans lequel
la feuille de dissipation de chaleur (12) est en contact surfacique avec au moins une partie de la surface extérieure du composant thermogène (11), ladite surface extérieure étant disposée en regard du substrat (10),
le dissipateur thermique (13) couvre une partie du composant thermogène (11), la feuille de dissipation (12) étant interposée entre eux, et est disposé sur le châssis métallique, et
la surface extérieure du composant chauffant (11) est une surface non plate ;
**caractérisé en ce que**
le dissipateur thermique (13) comprend deux parois latérales (132) et une partie corps principal plate (131) fixée au châssis métallique, les deux parois latérales (132) s'étendent de deux extrémités opposées de la partie corps principal (131) à un côté opposé au châssis métallique, et la partie corps principal (131) et les deux parois latérales (132) sont en butée contre la surface extérieure, la feuille de dissipation de chaleur (12) étant interposée entre elles.

2. Dispositif électronique selon la revendication 1, dans lequel
les parois latérales (132) sont incurvées ou plates, et forment un angle avec la partie corps principal (131).

3. Dispositif électronique selon la revendication 1 ou la revendication 2, dans lequel
les parties d'extrémité des parois latérales (132) sont courbées pour former des parties incurvées (133), et les parties incurvées (133) sont en butée contre la surface extérieure, la feuille de dissipation de chaleur (12) étant interposée entre elles.

4. Dispositif électronique selon l'une quelconque des revendications 1 à 3, dans lequel
la partie corps principal (131) du dissipateur thermique (13) est dotée d'une ou de deux vis, ou plus.

5. Dispositif électronique selon l'une quelconque des revendications 1 à 4, dans lequel
lorsque plus de deux composants thermogènes (11) sont prévus, le nombre de dissipateurs thermiques (13) est égal ou inférieur à celui des composants thermogènes (11), et une ou plusieurs feuilles de dissipation de chaleur (12) sont prévues.

6. Dispositif électronique selon les revendications 1 à 5, dans lequel
le dissipateur thermique (13) est constitué d'un matériau à haute conductivité thermique.

7. Dispositif électronique selon l'une quelconque des revendications 1 à 6, dans lequel
le dispositif électronique est une alimentation à découpage, et le composant thermogène (11) est un transformateur.

8. Dispositif électronique selon la revendication 7, dans lequel
le transformateur (11) est doté d'une base (111) fixée au substrat (10) et d'une partie thermogène (112) fixée à la base (111),
la partie thermogène (112) est dotée d'une partie en saillie (113) configurée pour faire saillie de la base (111) vers un côté en regard du substrat (10), et la feuille de dissipation de chaleur (12) est en contact surfacique avec la surface extérieure de la partie en saillie (113).

9. Dispositif électronique selon la revendication 8, dans lequel
la surface extérieure de la partie en saillie (113) est une surface incurvée, une surface comprenant une surface incurvée et une surface plate, ou une surface comprenant deux surfaces plates, ou plus.
